# EUROPEAN PATENT SPECIFICATION

(11) **EP 3 872 508 B1**
(45) Date of publication and mention of the grant of the patent: **18.11.2026**
(21) Application number: 19890181.1
(22) Date of filing: 29.11.2019
(51) Int. Cl.: G01R 31/389, G01R 31/396, G01R 27/26, G01R 31/3835, G01R 31/392, G01R 35/00, G01R 27/14, G01R 27/16

(54) **BATTERY CELL RESISTANCE MEASUREMENT DEVICE AND METHOD**
VORRICHTUNG UND VERFAHREN ZUR MESSUNG DES BATTERIEZELLENWIDERSTANDS
DISPOSITIF ET PROCÉDÉ DE MESURE DE LA RÉSISTANCE D'UNE CELLULE DE BATTERIE

(30) Priority: 30.11.2018 KR 20180152645
(43) Date of publication of application: 01.09.2021
(73) Proprietor: LG Energy Solution, Ltd., Seoul 07335 (KR)
(72) Inventor: BANG, Kyung Sup, Daejeon 34122 (KR)
(74) Representative: Hoffmann Eitle
(86) International application number: PCT/KR2019/016797
(87) International publication number: WO 2020/111896

(56) References cited:
- JP-A- 2008 016 275
- JP-A- 2010 223 968
- KR-A- 20090 056 847
- KR-A- 20180 062 814
- KR-A- 20180 062 814
- KR-B1- 101 160 545
- KR-B1- 101 160 545
- US-A1- 2017 003 354
- US-A1- 2017 219 660

## Description

### [TECHNICAL FIELD]

### Technical field

The present invention relates to a device and method for measuring battery cell resistance.

### [BACKGROUND ART]

In order to estimate battery resistance deterioration conventionally, by extracting the resistance data of the battery during the operating cycle, and using the resistance data extracted under a specific temperature and a specific state of charge (SOC) condition to calculate the ratio of resistance to the initial battery, the calculated resistance ratio was used for battery's real time SOC estimation, capacity estimation and battery life estimation.

However, such a battery resistance deterioration estimation method applies a degeneration rate only at a specific temperature and a specific SOC condition, so that it is difficult to accurately calculate the resistance of the battery according to the external noise and the external load.

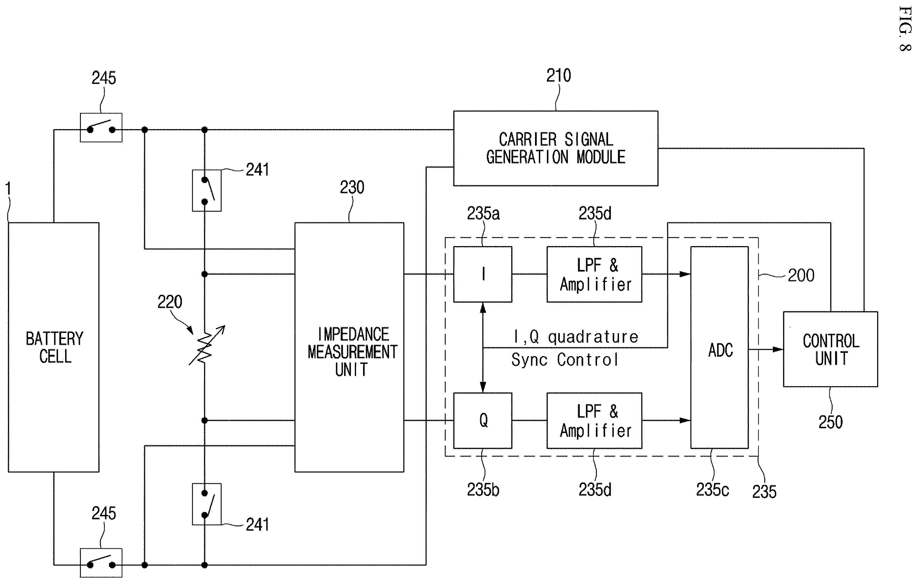

US 2017/003354 A1 relates to an apparatus for impedance measurement and, more specifically, to impedance measurement in energy storage cells employed in rechargeable service. An energy storage cell impedance measuring system 200 may include control circuitry 300 operably coupled to SOS current excitation circuitry 400 and an energy storage cell 210. The control circuitry 300 may be configured to measure only a voltage response of the energy storage cell 210 to the SOS signal 404. In such embodiments, calibration may be needed to determine the impedance of the energy storage cell 210. By way of non-limiting example, a method of single-shunt calibration is discussed below with reference to FIG. 8. In some embodiments, multiple shunt (e.g., resistive shunts) calibration may be used to account for real and imaginary portions of signals. An impedance computation module 350 may be configured to estimate the current response using the voltage response and calibration data from previous or subsequent calibrations of the control circuitry 300. A known calibration response may be measured by applying the SOS signal 404 to one or more shunts of known impedance and measuring and storing calibration data including the response of the one or more shunts to the SOS signal 404.

US 2017/219660 A1 relates to an electrochemical impedance spectroscopy in battery management systems.

KR 101 160 545 B1 relates to an apparatus for measuring state of health of rechargeable battery.

KR 2018 0062814 A relates to a method for testing secondary cell battery using metadata.

### [SUMMARY]

### [TECHNICAL PROBLEM]

The present invention has been made to solve the above problems, to provide a battery cell resistance measurement device and method and a battery pack capable of accurately measuring the internal resistance of the battery cell without being affected by changes in external noise and external load.

### [TECHNICAL SOLUTION]

The invention is solely defined by the appended claims. Embodiments not fully falling under the scope of the appended claims are to be merely considered as examples useful for understanding the invention.

### [ADVANTAGEOUS EFFECTS]

According to the present invention, it is possible to accurately measure the internal resistance of the battery cell without being affected by external noise and changes in load.

In addition, by using the measured internal resistance of the battery cell, it is possible to accurately predict the power of the battery cell and the life of the battery cell.

Other effects of the present invention will be further described according to the following examples.

### [BRIEF DESCRIPTION OF THE DRAWINGS]

FIG. 1 is a block diagram showing the configuration of a battery pack including a battery cell resistance measurement device according to an embodiment of the present invention.
FIG. 2 is a diagram illustrating an equivalent circuit of an open voltage state of a battery cell.
FIG. 3 is a detailed circuit diagram of a battery cell resistance measurement device according to an embodiment of the present invention.
FIG. 4 is a flowchart illustrating a battery cell resistance measurement method according to an embodiment of the present invention.
FIG. 5 is a first state diagram of a battery cell resistance measurement device according to an embodiment of the present invention.
FIG. 6 is a second state diagram of a battery cell resistance measurement device according to an embodiment of the present invention.
FIG. 7 is a third state diagram of a battery cell resistance measurement device according to an embodiment of the present invention.
FIG. 8 is a detailed circuit diagram of a battery cell resistance measurement device according to another embodiment of the present invention.

### [DETAILED DESCRIPTION]

Hereinafter, some embodiments of the present invention will be described in detail through exemplary drawings. It should be noted that, in assigning reference numerals to components of each drawing, although the components are displayed on different drawings, like reference numerals refer to like components. Additionally, in describing the inventive concept, detailed descriptions of well-known configurations or functions will be omitted if it is determined that they would obscure the subject matter of the inventive concept.

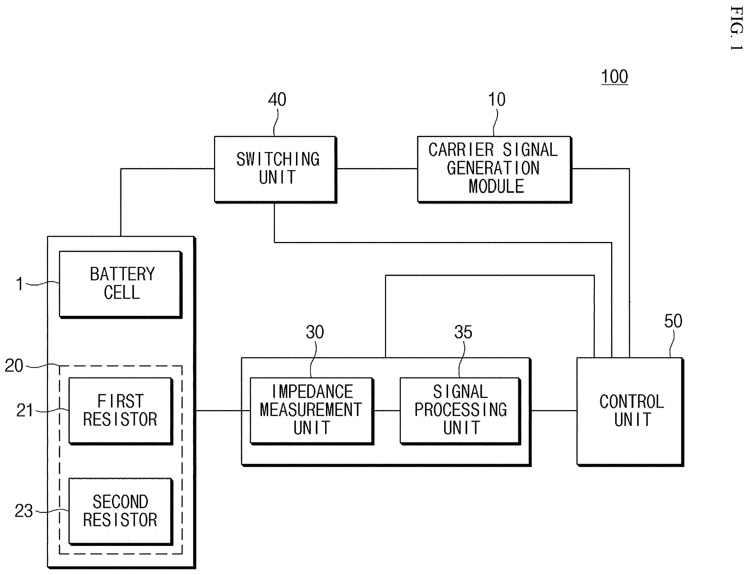

First, a battery cell resistance measurement device according to the present invention will be described with reference to FIG. 1. FIG. 1 is a block diagram showing the configuration of a battery pack 100 including a battery cell resistance measurement device according to an embodiment of the present invention.

As shown in FIG. 1, a battery cell resistance measurement device according to an embodiment of the present invention includes a carrier signal generation module 10, a resistance unit 20, an impedance measurement unit 30, a switching unit 40, and a control unit 50.

First, the carrier signal generation module 10 is a module for generating carrier signals of the first frequency and the second frequency and generates a current signal as a carrier signal having a high impedance to be injected into the battery cell 1. Here, if the impedance is small, since the measured value may vary depending on the load impedance, the carrier signal generation module 10 has a high impedance which is not affected by the load impedance, and generates and outputs a carrier signal of the first frequency or the second frequency as a constant current waveform by the frequency control signal of the control unit 50.

As an example, the carrier signal of the first frequency is a high impedance carrier signal at a preset low frequency and further, the carrier signal of the second frequency is a high impedance carrier signal at a preset high frequency. In other words, the carrier signal of the first frequency is a high impedance carrier signal below the first reference frequency, and the carrier signal of the second frequency is a high impedance carrier signal above the second reference frequency. Here, the first reference frequency is smaller than the second reference frequency. For example, the first reference frequency may be a low frequency of 1 to 2 Hz or less, and the second reference frequency may be a high frequency of 10 kHz or more.

The resistance unit 20 includes a plurality of resistors, and includes at least a first resistor 21 and a second resistor 23. In one example, the first resistor 21 is set to the expected lowest resistance value when the battery cell 1 is in an open voltage state. For example, the first resistor 21 may be set to 0 ohms as a minimum value for making the reference value to a value assuming that the battery impedance is shorted. In addition, the second resistor 23 is set to an expected maximum resistance value when the battery cell 1 is in an open voltage state. For example, the second resistor 23 may be set in the range of 0.05 ohm to 0.3 ohm as a maximum value margined in consideration of degeneration of the battery and the like.

The impedance measurement unit 30 has a configuration which measures the impedance of both ends of the corresponding application object in a state where a carrier signal of the first or second frequency is applied to any one of the first resistor 21, the second resistor 23, and the battery cell 1. For example, in a state where a first frequency carrier signal is applied to the first resistor 21, the impedance measurement unit 30 may measure the impedance of both ends of the first resistor 21, and in a state where a second frequency carrier signal is applied to the first resistor 21, the impedance measurement unit 30 may measure the impedance of both ends of the first resistor 21. In the same manner, the respective impedances can also be measured for the second resistor 23 and the battery cell 1.

In addition, the impedance measurement unit 30 may further include a signal processing unit 35 for generating an I signal of the same phase and a Q signal delayed by 90 degrees with respect to each of the measured impedance signals and removing a noise component from each measured impedance signal based on the generated I/Q signals. Accordingly, the influence by external noise can be eliminated.

In one example, the impedance measurement unit 30 and the signal processing unit 35 may be implemented as one configuration, or may be implemented in a separate configuration.

The switching unit 40 has a configuration for selectively connecting any one of the first resistor 21, the second resistor 23, and the battery cell 1 to the impedance measurement unit 30. For example, the first resistor and/or the second resistor may be configured to be connected in parallel between both ends of the battery cell 1 through the switches of the switching unit 40. Accordingly, by controlling ON/OFF of each switch of the switching unit 40, only one of the first resistor 21, the second resistor 23, and the battery cell 1 may be connected to the carrier signal generation module 10 and the impedance measurement unit 30. The switching unit 40 may be controlled by the switching control signal of the control unit 50 or the impedance measurement unit 30.

Furthermore, the control unit 50 is a processing unit that calculates the internal resistance of the battery cell 1 based on the impedance value measured by the impedance measurement unit 30.

In detail, the control unit 50 generates the adjustment parameter based on the measured impedance value by applying the carrier signal of the first frequency and the carrier signal of the second frequency, respectively, with respect to each of the first resistor 21 and the second resistor 23.

For example, based on the first impedance value measured by applying the carrier signal of the first frequency to the first resistor 21 and the second impedance value measured by applying the carrier signal of the first frequency to the second resistor 23, a first adjustment parameter is generated at the first frequency. In addition, based on the third impedance value measured by applying the carrier signal of the second frequency to the first resistor 21 and the fourth impedance value measured by applying the carrier signal of the second frequency to the second resistor 23, a second adjustment parameter may be generated at the second frequency.

Furthermore, based on the impedance value and the adjustment parameter measured by applying the carrier signal of the first frequency and the carrier signal of the second frequency with respect to the battery cell 1, the control unit 50 calculates the internal resistance of the battery cell. For example, the fifth impedance value measured by applying the carrier signal of the first frequency to the battery cell 1 may be adjusted based on the first adjustment parameter at the first frequency, and the sixth impedance value measured by applying the carrier signal of the second frequency to the battery cell 1 may be adjusted based on the second adjustment parameter at the second frequency.

Also, when calculating the internal resistance of the battery cell, by using carrier signals of the first and second frequencies, the control unit 50 can calculate the DC component resistance and the AC component impedance of the internal resistance, respectively.

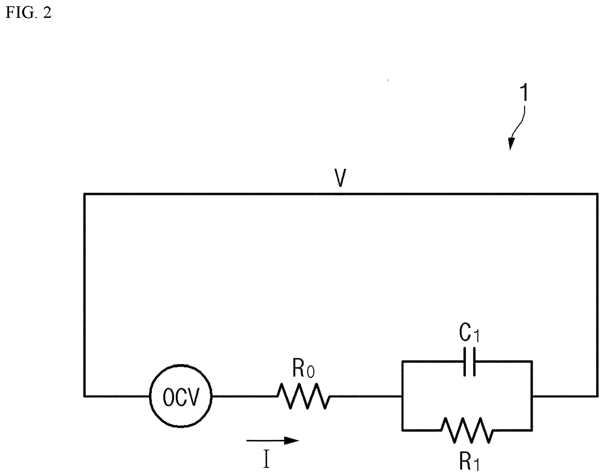

Here, the internal resistance component of the battery cell will be described with reference to FIG. 2. FIG. 2 is a diagram illustrating an equivalent circuit of an open voltage state of a battery cell.

As shown in FIG. 2, the battery cell 1 is formed of a circuit in which a resistor R0, and a capacitor C1 and a resistor R1 of a parallel structure are connected in series in an open voltage state. The resistor R0 represents a DC component resistance, and the resistor R1 represents an AC component impedance. In other words, the internal resistance of the battery cell 1 consists of the resistor R0 and the resistor R1. By measuring such resistance R0 and resistance R1, it can use for SOC estimation, capacity estimation, life estimation, etc.

Referring to FIG. 1 again, for example, the control unit 50 adjusts the fifth impedance value measured by applying the carrier signal of the first frequency to the battery cell 1 based on the first adjustment parameter, the total internal resistance including the DC component resistance and AC component impedance of the battery cell 1 is calculated. In other words, when a high impedance carrier signal of a first frequency, that is, a low frequency, is applied to the battery cell 1, the impedance value measured from the battery cell 1 becomes a total impedance value in which the DC component resistance R0 and the AC component impedance R1 are added together. This is because the low-frequency high impedance carrier signal is measured by passing through the DC component resistance R0 and the AC component impedance R1 inside the battery cell 1.

Also, by adjusting the sixth impedance value measured by applying a carrier signal of the second frequency to the battery cell 1 based on the second adjustment parameter, the control unit 50 calculates the DC component resistance of the battery cell 1. In other words, when a high impedance carrier signal of a second frequency, that is, a high frequency, is applied to the battery cell 1, the impedance value measured from the battery cell 1 becomes the impedance value of only the DC component resistance R0. This is because a highfrequency high impedance carrier signal is measured through the DC component resistance R0 and the capacitor C1 inside the battery cell 1.

Accordingly, by subtracting the calculated DC component resistance from the calculated total internal resistance to calculate the AC component impedance, the control unit 50 can calculate the DC component resistance and the AC component impedance of the internal resistance, respectively.

In the above description, although it has been described that the control unit 50 calculates the internal resistance based on the impedance value measured by the impedance measurement unit 30, in consideration of not only the measured impedance value but also the actual temperature and SOC of the battery cell 1, the internal resistance of the battery cell 1 may be calculated.

Accordingly, the control unit 50 can calculate the capacity of the battery cell 1 using the calculated DC component resistance and AC component impedance.

Alternatively, the control unit 50 may predict the life of the battery cell using the calculated DC component resistance and AC component impedance.

In such a manner, according to the present invention, it is possible to accurately measure the internal resistance of the battery cell without being affected by external noise and changes in load. In addition, by using the measured internal resistance of the battery cell, it is possible to accurately predict the capacity of the battery cell and the life of the battery cell.

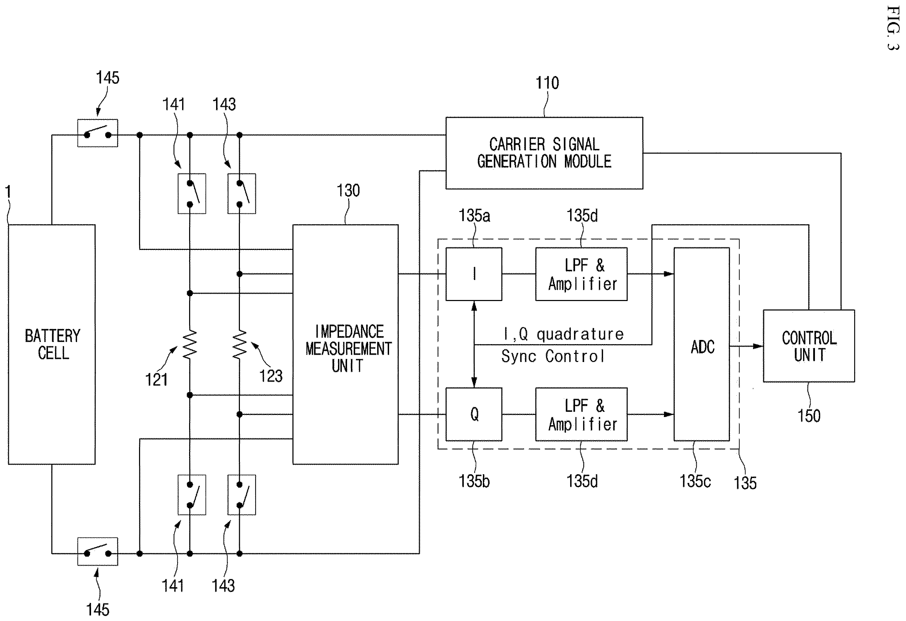

As an embodiment, a battery cell resistance measurement device will be described with reference to FIG. 3. FIG. 3 is a detailed circuit diagram of a battery cell resistance measurement device according to an embodiment of the present invention.

As shown in FIG. 3, the battery cell resistance measurement device according to an embodiment of the present invention includes a carrier signal generation module 110, a first resistor 121, a second resistor 123, an impedance measurement unit 130, a switching unit, a signal processing unit 135, and a control unit 150.

First, the carrier signal generation module 110 receives a frequency control signal from the control unit 150 to generate a high impedance carrier signal of a predetermined low frequency (first frequency) or a predetermined high frequency (second frequency), and applies the generated high impedance carrier signal to any one of the battery cell 1, the first resistor 121, and the second resistor 123. The battery cell 1, the first resistor 121, and the second resistor 123 have a parallel structure.

The first resistor 121 has a resistance value of 0 ohms as an expected minimum resistance value when the battery cell is in an open voltage state, and the second resistor 123 has a resistance value of 0.05 ohms as an expected maximum resistance value when the battery cell is in an open voltage state.

The impedance measurement unit 130 is connected to common both ends of the battery cell 1, the first resistor 121, and the second resistor 123, which form a parallel structure, and measures an impedance value, that is, an impedance signal, from an application target selected from the battery cell 1, the first resistor 121, or the second resistor 123. Although not shown in the drawing, the impedance measurement unit 130 may include amplification means for primarily amplifying the impedance signal.

Subsequently, the switching unit is switching means for selectively applying a high impedance carrier signal to any one of the battery cell 1, the first resistor 121, or the second resistor 123, and for example, includes a first switch 141 connected in series to both ends of the first resistor 121, a second switch 143 connected in series to both ends of the second resistor 123, and a third switch 145 connected in series to both ends of the battery cell 1. For example, the first to third switches 141, 143, and 145 of the switching unit may operate by a switching control signal of the control unit 150, or may operate by a switching control signal from the impedance measurement unit 130.

Then, the signal processing unit 135 is, for example, a configuration to perform the signal processing of the orthogonal modulation method on the impedance signal received through the impedance measurement unit 130 to remove the influence of external noise, etc., and for example, includes an I circuit 135a for outputting an I signal of the same phase with respect to an impedance signal received through the impedance measurement unit 130, a Q circuit 135b for outputting a Q signal delayed by 90 degrees with respect to the impedance signal received through the impedance measurement unit 130, and an analog-to-digital converter (ADC) unit 135c for receiving the outputted I signal and Q signal, and performing analog-to-digital conversion and synthesis to remove the noise component. Also, a low pass filter and an amplifier unit 135d for low pass filtering and amplifying a corresponding output signal are included between the I circuit 135a and the ADC section 135c and between the Q circuit 135b and the ADC section 135c, respectively.

For example, as a constant current waveform outputted from the carrier signal generation module 110, when the carrier signal is sin(wt+θ) and the internal impedance of the battery cell 1 is A, the impedance signal measured and outputted to the impedance measurement unit 130 becomes Asin(wt+θ). The I circuit 135a receives Asin(wt+θ) from the impedance measurement unit 130 and receives a synchronous frequency control signal of Asin(wt+θ1) from the control unit 150 and outputs Asin(wt+θ)*Asin(wt+θ1)=A/2cos(θ-θ1)-A/2cos(2wt+θ+θ1). At this time, among the signal components outputted from the I circuit 135a by the low pass filter and the amplifier unit 135d, the signal component of - A/2cos(2wt+θ+θ1) is removed, so that A/2cos(θ-θ1)=I(x) is inputted to the ADC unit 135c. Meanwhile, the Q circuit 135b receives Asin(wt+θ) from the impedance measurement unit 130 and receives a frequency control signal delayed by 90 degrees of Asin(wt+θ1+90°) from the control unit 150, and outputs Asin(wt+θ)*Asin(wt+θ1+90°)=A/2cos(θ-θ1-90°)-A/2cos(2wt+θ+θ1+90°). At this time, among the signal components outputted from the Q circuit 135b by the low pass filter and the amplifier unit 135d, the signal component of - A/2cos(2wt+θ+θ1+90°) is removed, so that A/2cos(θ-θ1-90°)=Q(y) is inputted to the ADC unit 135c. Subsequently, the ADC unit 135c analog-to-digital converts the input signals, synthesizes the converted signals by $\sqrt{I {\left(x\right)}^{2} + Q {\left(y\right)}^{2}}$, and outputs the synthesized signal.

Through this, the control unit 150 may receive and calculate the internal impedance A of the battery cell 1 from which the noise component is removed. In this manner, the signal processing unit 135 may remove the influence of external noise or the like on the impedance signal received through the impedance measurement unit 130.

Then, the control unit 150 calculates the internal resistance of the battery cell based on the impedance value measured by the impedance measurement unit 130, but generates an adjustment parameter based on an impedance value measured by applying a low frequency carrier signal and a high frequency carrier signal to each of the first resistor 121 and the second resistor 123, and adjusts the impedance value measured by applying a low frequency carrier signal and a high frequency carrier signal to the battery cell based on the adjustment parameter to calculate the internal resistance of the battery cell. At this time, the DC component resistance and the AC component impedance are respectively calculated as the internal resistance of the battery cell.

For example, in order to generate an adjustment parameter, the control unit 150 controls the first switch 141 to ON and the second and third switches 143 and 145 to OFF, and controls the carrier signal generation module 110 to output a low frequency high impedance carrier signal, so that it measures a first impedance value of the first resistor 121, controls the second switch 143 to ON, controls the first and third switches 141 and 145 to OFF, and controls the carrier signal generation module 110 to output a low frequency high impedance carrier signal so as to measure the second impedance value at the second resistor 123 and generate a first adjustment parameter at low frequency. Also, the control unit 150 controls the first switch 141 to ON and the second and third switches 143 and 145 to OFF and controls the carrier signal generation module 110 to output a high frequency high impedance carrier signal so that it measures a third impedance value of the first resistor 121, controls the second switch 143 to ON, controls the first and third switches 141 and 145 to OFF, and controls the carrier signal generation module 110 to output a high frequency high impedance carrier signal so as to measure the fourth impedance value at the second resistor 123 and generate a second adjustment parameter at high frequency. Here, the order of measuring the first to fourth impedance values is not particularly limited, and may be variously changed.

In addition, in order to calculate the DC component resistance and the AC component impedance which are internal resistances of the battery cell, respectively, for example, the control unit 150 controls the third switch 145 to ON and the first and second switches 141 and 143 to OFF, and controls the carrier signal generation module 110 to output a low frequency high impedance carrier signal so that it adjusts the fifth impedance value measured from the battery cell 1 based on the first adjustment parameter. At this time, when a low frequency high impedance carrier signal is applied to the battery cell 1, the impedance value measured from the battery cell 1 becomes a total impedance value obtained by adding the DC component resistance and the AC component impedance. In addition, the control unit 150 controls the third switch 145 to ON and the first and second switches 141 and 143 to OFF and controls the carrier signal generation module 110 to output a high frequency high impedance carrier signal so that it measures the impedance value in the battery cell 1 and adjusts the measured impedance value based on the adjustment parameter at high frequency. At this time, when a high frequency high impedance carrier signal is applied to the battery cell 1, the impedance value measured from the battery cell 1 becomes the impedance value of only the DC component resistance. In addition, the control unit 150 obtains the AC component impedance value by subtracting the impedance value of the DC component resistance only from the total impedance value.

Accordingly, the control unit 150 may accurately calculate the DC component resistance and the AC component impedance, which are internal resistances of the battery cell, respectively.

As described above, since the present invention calculates the DC component resistance and the AC component impedance, which are internal resistances of the battery cell, using low and high frequency, that is, multi-frequency high impedance carrier signals, the internal resistance of the battery cell can be calculated accurately without being affected by the external load of the battery cell.

In addition, the control unit 150 may calculate the capacity of the battery cell 1 or predict the life of the battery cell 1 using the calculated DC component resistance and AC component impedance. For example, a reference change table is prepared by comparing and analyzing actual measured values of a predetermined period of internal resistance components R0 and R1 of a battery after initial battery cell is mounted, so that capacity can be calculated and lifespan can be predicted. As described above, since it is a well-known technique to calculate the capacity of the battery cell 1 and predict the life thereof, detailed description thereof will be omitted.

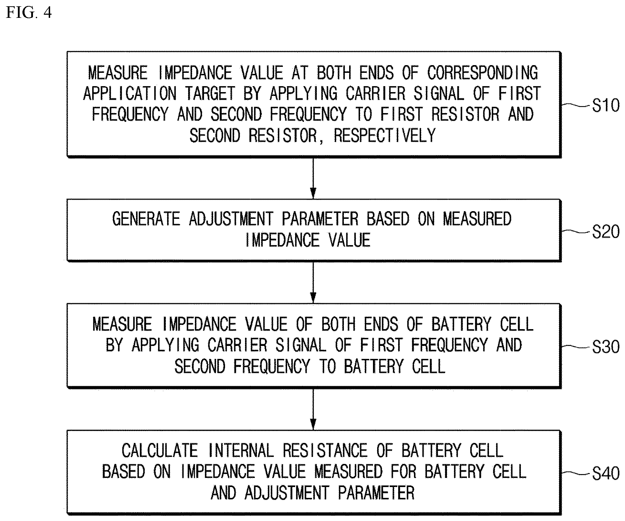

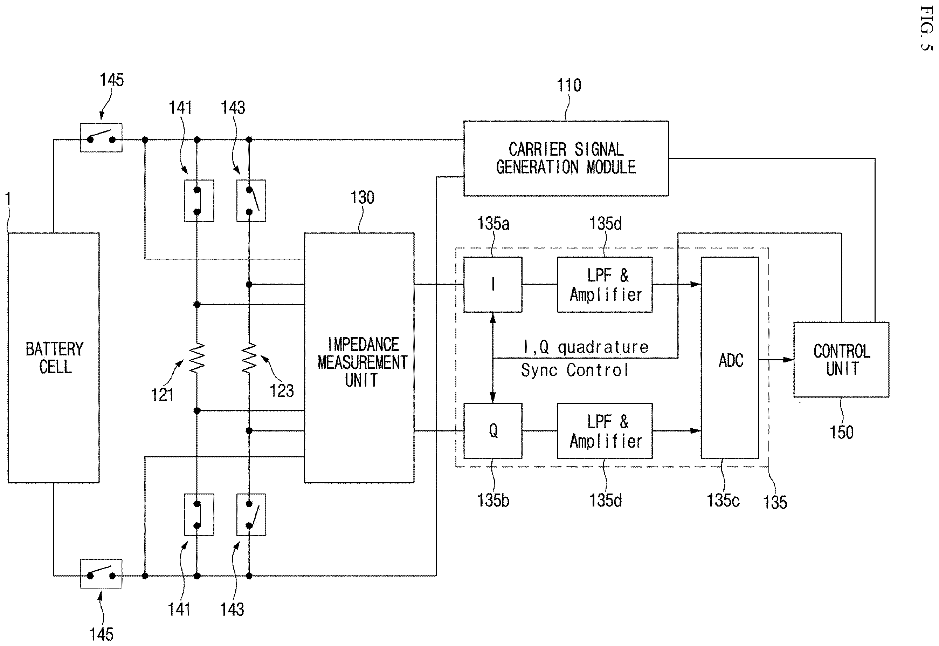

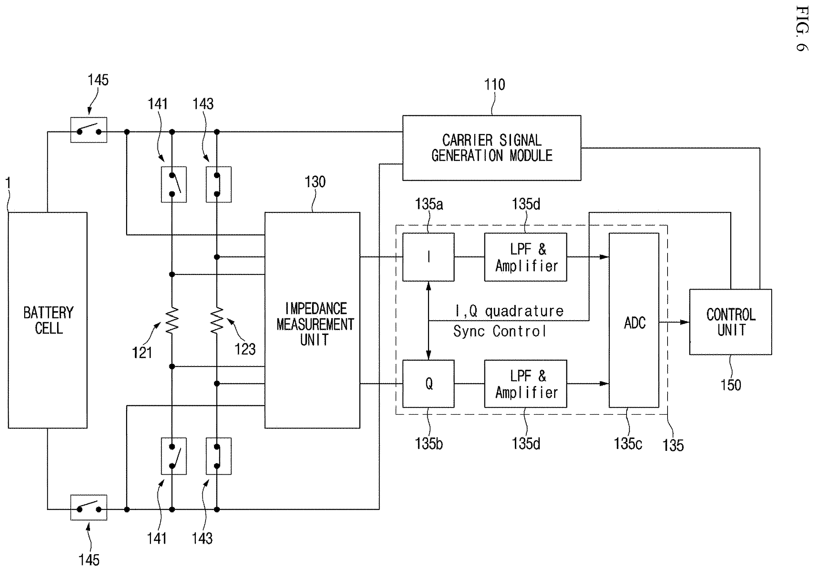

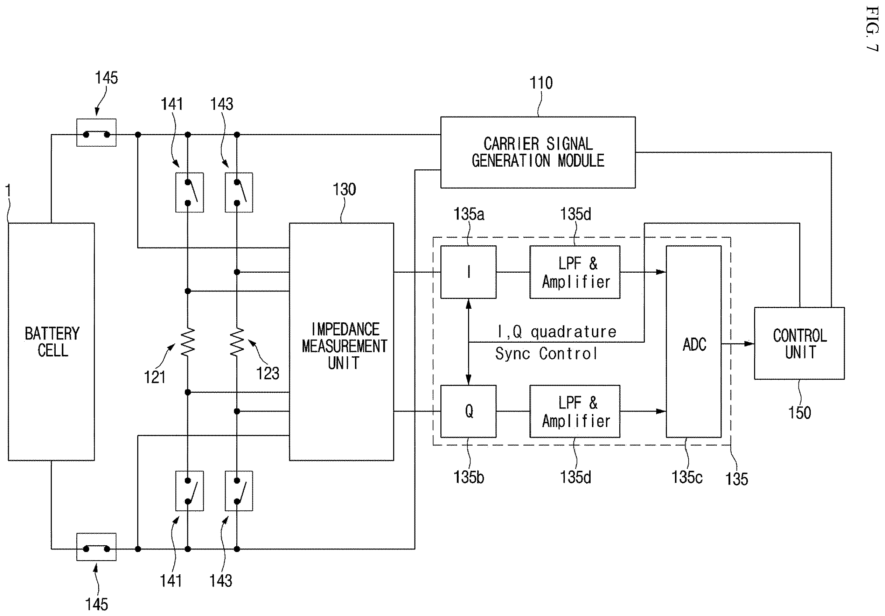

Next, the battery cell resistance measurement method according to the present invention will be described with reference to FIGS. 4 to 7. FIG. 4 is a flowchart illustrating a method of measuring battery cell resistance according to an embodiment of the present invention. FIG. 5 is a first state diagram of a battery cell resistance measurement device according to an embodiment of the present invention. FIG. 6 is a second state diagram of a battery cell resistance measurement device according to an embodiment of the present invention. FIG. 7 is a third state diagram of a battery cell resistance measurement device according to an embodiment of the present invention.

First, as shown in FIG. 4, the battery cell resistance measurement method according to an embodiment of the present invention first measures the impedance value at both ends of the application target in a state where a carrier signal of a first frequency and a second frequency is applied to each of the first resistor and the second resistor (S10).

Here, the switching unit is controlled so as to be in a state of applying a carrier signal of a first frequency and a second frequency to each of the first and second resistors. For example, as in FIG. 5, by turning on the first switch 141 and turning off the second and third switches 143, 145, it allows a high impedance carrier signal from carrier signal generation module 110 to be selectively applied to first resistor 121, and also, as in FIG. 6, by turning on the second switch 143 and turning off the first and third switches 141 and 145, the high impedance carrier signal from carrier signal generation module 110 may be selectively applied to second resistor 123. By this, for example, a carrier signal of the first frequency is applied to the first resistor 121 to measure the first impedance value from the first resistor 121, and a carrier signal of the first frequency is applied to the second resistor 123 to measure the second impedance value from the second resistor123. In addition, a carrier signal of the second frequency is applied to the first resistor 121 to measure the third impedance value from the first resistor 121, and a carrier signal of the second frequency is applied to the second resistor 123 to measure the fourth impedance value from the second resistor123. Here, the order of measuring the first to fourth impedance values is not particularly limited, and may be measured in various orders according to the measurement environment and the setting order.

Subsequently, an adjustment parameter is generated based on the measured impedance value (S20). For example, the control unit 150 generates a first adjustment parameter at the first frequency based on the first impedance value and the second impedance value. Further, based on the third impedance value and the fourth impedance value, a second adjustment parameter at the second frequency is generated. Here, the order of generating the first and second adjustment parameters is not particularly limited.

Subsequently, in a state where carrier signals of a first frequency and a second frequency are respectively applied to the battery cells, impedance values of both ends of the battery cells are measured (S30).

Here, the switching unit is controlled so as to be in a state of applying a carrier signal of a first frequency and a second frequency to the battery cell. For example, as in FIG. 7, by turning on the third switch 145 and turning off the first and second switches 141, 143, the high impedance carrier signal from the carrier signal generation module 110 may be selectively applied to the battery cell 1. Thus, for example, the carrier signal of the first frequency is applied to the battery cell 1 to measure the fifth impedance value from the battery cell, and the carrier signal of the second frequency is applied to the battery 1 to measure the sixth impedance value from the battery cell. Here, the order of measuring the fifth and sixth impedance values is not particularly limited.

Subsequently, the internal resistance of the battery cell is calculated based on the impedance value and the adjustment parameter measured for the battery cell (S40).

For example, the calculating of the internal resistance of the battery cell (S40) may calculate the DC component resistance and the AC component impedance of the internal resistance, respectively. Specifically, in the calculating of the internal resistance of the battery cell (S40), the total internal resistance including the DC component resistance and AC component impedance of the battery cell can be calculated by adjusting the fifth impedance value based on the first adjustment parameter, and in addition, the DC component resistance of the battery cell can be calculated by adjusting the sixth impedance value based on the second adjustment parameter, and the AC component impedance can be calculated by subtracting the calculated DC component resistance from the calculated total internal resistance, so that the DC component resistance and the AC component impedance of the internal resistance can be calculated, respectively.

In one example, in the measuring of the first to sixth impedance values (S10, S30), an I signal of the same phase and a Q signal delayed by 90 degrees can be generated for each measured impedance signal, and based on the generated I/Q signals, signal processing for removing noise components from each of the measured impedance signals can be performed. Accordingly, the influence by external noise can be eliminated.

In addition, although not shown in the drawing, a battery cell resistance measurement method according to an embodiment of the present invention may further include at least one of calculating the capacity of the battery cell 1 using the calculated DC component resistance and AC component impedance and predicting the life of the battery cell by using the calculated DC component resistance and AC component impedance.

In another embodiment, although it is shown that the resistance unit 20 includes a plurality of resistors 21 and 23 in the foregoing embodiment, for example, one variable resistor may be used.

FIG. 8 is a detailed circuit diagram of a battery cell resistance measurement device according to another embodiment of the present invention.

As shown in FIG. 8, the battery cell resistance measurement device according to another embodiment of the present invention includes a carrier signal generation module 210, a variable resistor 220, an impedance measurement unit 230, switching units 241 and 245, a signal processing unit 235, and a control unit 250.

Here, the resistance value of the variable resistor 220 may be changed by the impedance measurement unit 230 or the control unit 250. For example, the battery cell 1 may be adjusted to have a resistance value of 0 ohms as an expected minimum resistance value when the battery cell 1 is in an open state, or the battery cell 1 may be adjusted to have a resistance value of 0.05 ohms as an expected maximum resistance value when the battery cell 1 is in an open voltage state. At this time, for example, the first switch 241 controls ON and the second switch 245 controls OFF, and a low frequency carrier signal and a high frequency carrier signal from the carrier signal generation module 210 are applied to the variable resistor 220, so that by measuring the impedance value at each resistance value of the variable resistor 220, an adjustment parameter can be generated.

Since the detailed descriptions of the carrier signal generation module 210, the impedance measurement unit 230, the switching units 241 and 245, the signal processing unit 235, and the control unit 250 are the same as the descriptions of the carrier signal generation module 110, the impedance measurement unit 130, the switching unit, the signal processing unit 135, and the control unit 150 in FIG. 3, their detailed description will be omitted.

In addition, in the above embodiment, the switching unit is connected in series to both ends of each of the battery cell 1 and the first and second resistors 121 and 123 (or the variable resistor 220) but may be connected in series to only one end of the both ends of each of the battery cell 1 and the first and second resistors 121 and 123 (or the variable resistor 220). That is, the high impedance carrier signal of the carrier signal generation modules 110 and 210 may be selectively applied to any one of the battery cell 1 and the first and second resistors 121 and 123 (or the variable resistor 220).

Meanwhile, the present invention may be implemented as a battery pack. For example, a battery pack according to an embodiment of the present invention may include at least one battery cell that can be charged and discharged; a battery management system for controlling charging and discharging of the battery cell; and a battery cell resistance measurement device for measuring the internal resistance of the battery cell.

As described above, according to the present invention, it is possible to accurately measure the internal resistance of battery cells without being affected by external noise or changes in external loads and in addition, by using the measured internal resistance of the battery cell, it is possible to accurately predict the power of the battery cell and the life of the battery cell.

Although the present invention has been described above by limited embodiments and drawings, the present invention is not limited thereto, and it will be apparent to those skilled in the art that the present invention may be implemented in various ways within the scope of the claims to be described below.

## Claims

1. A battery cell resistance measurement device comprising:
a carrier signal generation module (10) configured to generate a first carrier signal at a first frequency and a second carrier signal at a second frequency different from the first frequency;
a first resistor (21);
a second resistor (23) having a different resistance value from the first resistor;
an impedance measurement unit (30) configured to measure an impedance of a target while the first or second carrier signal is applied to the target;
a switching unit (40) configured to selectively connect any one of the first resistor, the second resistor, and the battery cell (1) to the impedance measurement unit, wherein whichever of the first resistor, the second resistor, or the battery cell that is connected to the impedance measurement unit is the target; and
a control unit (50) configured to calculate an internal resistance of the battery cell based on the impedance of one or more targets measured by the impedance measurement unit,
wherein the control unit (50) is configured to:
generate an adjustment parameter based on an impedance value measured by applying each of the first and second carrier signals to each of the first resistor and the second resistor, and
calculate an internal resistance of the battery cell based on an impedance value measured by applying the first and second carrier signals to the battery cell and the adjustment parameter.

2. The battery cell resistance measurement device of claim 1, wherein the first carrier signal is a high impedance carrier signal at a frequency equal to or less than a preset first reference frequency,
wherein the second carrier signal is a high impedance carrier signal at a frequency equal to or greater than a preset second reference frequency, and
wherein the first reference frequency is less than the second reference frequency.

3. The battery cell resistance measurement device of claim 1, wherein a resistance of the first resistor is an expected minimum resistance value when the battery cell is in an open voltage state,
wherein a resistance of the second resistor is an expected maximum resistance value when the battery cell is in an open voltage state.

4. The battery cell resistance measurement device of claim 1, wherein the impedance measurement unit (30) further comprises a signal processing unit configured to:
generate an I signal of the same phase as an impedance signal received through the impedance measurement unit and a Q signal delayed by 90 degrees with respect to the impedance signal; and
remove a noise component from the measured impedance signal based on the generated I signal and the generated Q signal.

5. The battery cell resistance measurement device of claim 1, wherein the control unit (50) is configured to calculate a DC component resistance and an AC component impedance of an internal resistance using the first and second carrier signals.

6. The battery cell resistance measurement device of claim 5, wherein the control unit (50) is configured to calculate a capacity of the battery cell based on the calculated DC component resistance and AC component impedance.

7. The battery cell resistance measurement device of claim 5, wherein the control unit (50) is configured to estimate a life of the battery cell based on the calculated DC component resistance and AC component impedance.

8. A battery cell resistance measurement method comprising:
generating a first carrier signal at a first frequency and a second carrier signal at a second frequency different from the first frequency;
measuring, by means of impedance measurement unit, an impedance of a target while the first or second carrier signal is applied to the target;
selectively connecting any one of a first resistor, a second resistor, and a battery cell (1) to the impedance measurement unit, wherein whichever of the first resistor, the second resistor, or the battery cell that is connected to the impedance measurement unit is the target;
calculating an internal resistance of the battery cell based on the impedance of one or more targets measured by the impedance measurement unit,
**characterised in that** the method further comprises:
generating an adjustment parameter based on an impedance value measured by applying each of the first and second carrier signals to each of the first resistor and the second resistor, and
calculating an internal resistance of the battery cell based on an impedance value measured by applying the first and second carrier signals to the battery cell and the adjustment parameter.

9. The battery cell resistance measurement method of claim 8, wherein the first carrier signal is a high impedance carrier signal at a frequency equal to or less than a preset first reference frequency,
wherein the second carrier signal is a high impedance carrier signal at a frequency equal to or greater than a preset second reference frequency,
wherein the first reference frequency is less than the second reference frequency.

10. The battery cell resistance measurement method of claim 9, wherein calculating of the internal resistance of the battery cell comprises:
calculating a total internal resistance including a DC component resistance and an AC component impedance of the battery cell based on the first adjustment parameter and a fourth impedance value measured from the battery cell by applying the first carrier signal to the battery cell;
calculating the DC component resistance of the battery cell based on the second adjustment parameter and a fifth impedance value measured from the battery cell by applying the second carrier signal of the second frequency to the battery cell; and
calculating the AC component impedance of the internal resistance of the battery cell by subtracting the calculated DC component resistance from the calculated total internal resistance.

11. The battery cell resistance measurement method of claim 8, wherein a resistance of the first resistor is at an expected minimum resistance value when the battery cell is in an open voltage state,
wherein a resistance of the second resistor is at an expected maximum resistance value when the battery cell is in an open voltage state.

12. The battery cell resistance measurement method of claim 8, wherein the measuring of the impedance value of the target comprises:
generating an I signal of the same phase as an impedance signal and a Q signal delayed by 90 degrees with respect to the impedance signal; and
performing signal processing to remove a noise component from the measured impedance signal based on the generated I signal and the generated Q signal.

## Patentansprüche

1. Vorrichtung zur Messung des Batteriezellenwiderstands, umfassend:
ein Trägersignalerzeugungsmodul (10), das ausgebildet ist, um ein erstes Trägersignal bei einer ersten Frequenz und ein zweites Trägersignal bei einer zweiten Frequenz zu erzeugen, die sich von der ersten Frequenz unterscheidet;
einen ersten Widerstand (21);
einen zweiten Widerstand (23), der einen vom ersten Widerstand unterschiedlichen Widerstandswert aufweist;
eine Impedanzmesseinheit (30), die ausgebildet ist, um eine Impedanz eines Ziels zu messen, während das erste oder das zweite Trägersignal am Ziel angelegt ist;
eine Schalteinheit (40), die ausgebildet ist, um selektiv ein beliebiges von dem ersten Widerstand, dem zweiten Widerstand und der Batteriezelle (1) mit der Impedanzmesseinheit zu verbinden, wobei dasjenige von dem ersten Widerstand, dem zweiten Widerstand oder der Batteriezelle, das mit der Impedanzmesseinheit verbunden wird, das Ziel ist; und
eine Steuereinheit (50), die ausgebildet ist, einen Innenwiderstand der Batteriezelle auf der Grundlage der Impedanz eines oder mehrerer Ziele, die von der Impedanzmesseinheit gemessen wird, zu berechnen,
wobei die Steuereinheit (50) ausgebildet ist zu Folgendem:
Erzeugen eines Einstellungsparameters auf der Grundlage eines Impedanzwerts, der durch Anlegen jedes von dem ersten und dem zweiten Trägersignal an jedem von dem ersten Widerstand und dem zweiten Widerstand gemessen wird, und
Berechnen eines Innenwiderstands der Batteriezelle auf der Grundlage eines Impedanzwerts, der durch Anlegen des ersten und des zweiten Trägersignals an der Batteriezelle und des Einstellungsparameters gemessen wird.

2. Vorrichtung zur Messung des Batteriezellenwiderstands nach Anspruch 1, wobei das erste Trägersignal ein Trägersignal mit hoher Impedanz bei einer Frequenz von gleich oder kleiner als eine voreingestellte erste Referenzfrequenz ist,
wobei das zweite Trägersignal ein Trägersignal mit hoher Impedanz bei einer Frequenz von gleich oder größer als einer voreingestellten zweiten Referenzfrequenz ist, und
wobei die erste Referenzfrequenz kleiner als die zweite Referenzfrequenz ist.

3. Vorrichtung zur Messung des Batteriezellenwiderstands nach Anspruch 1, wobei ein Widerstand des ersten Widerstands ein erwarteter minimaler Widerstandswert ist, wenn die Batteriezelle in einem offenen Spannungszustand ist,
wobei ein Widerstand des zweiten Widerstands ein erwarteter maximaler Widerstandswert ist, wenn die Batteriezelle in einem offenen Spannungszustand ist.

4. Vorrichtung zur Messung des Batteriezellenwiderstands nach Anspruch 1, wobei die Impedanzmesseinheit (30) weiter eine Signalverarbeitungseinheit umfasst, die zu Folgendem ausgebildet ist:
Erzeugen eines I-Signals der gleichen Phase wie ein Impedanzsignal, das durch die Impedanzmesseinheit empfangen wird, und eines Q-Signals, das um 90 Grad in Bezug auf das Impedanzsignal verzögert ist; und
Entfernen einer Geräuschkomponente aus dem gemessenen Impedanzsignal auf der Grundlage des erzeugten I-Signals und des erzeugten Q-Signals.

5. Vorrichtung zur Messung des Batteriezellenwiderstands nach Anspruch 1, wobei die Steuereinheit (50) ausgebildet ist, um einen Gleichstromkomponentenwiderstand und eine Wechselstromkomponentenimpedanz eines Innenwiderstands unter Verwendung des ersten und des zweiten Trägersignals zu berechnen.

6. Vorrichtung zur Messung des Batteriezellenwiderstands nach Anspruch 5, wobei die Steuereinheit (50) ausgebildet ist, um eine Kapazität der Batteriezelle auf der Grundlage des berechneten Gleichstromkomponentenwiderstands und der berechneten Wechselstromkomponentenimpedanz zu berechnen.

7. Vorrichtung zur Messung des Batteriezellenwiderstands nach Anspruch 5, wobei die Steuereinheit (50) ausgebildet ist, um eine Lebenserwartung der Batteriezelle auf der Grundlage des Gleichstromkomponentenwiderstands und der berechneten Wechselstromkomponentenimpedanz zu schätzen.

8. Verfahren zur Messung des Batteriezellenwiderstands, umfassend:
Erzeugen eines ersten Trägersignals bei einer ersten Frequenz und eines zweiten Trägersignals bei einer zweiten Frequenz, die sich von der ersten Frequenz unterscheidet;
Messen, mithilfe der Impedanzmesseinheit, einer Impedanz eines Ziels, während das erste oder das zweite Trägersignal am Ziel angelegt sind;
selektives Verbinden eines beliebigen von einem ersten Widerstand, einem zweiten Widerstand und einer Batteriezelle (1) mit der Impedanzmesseinheit, wobei dasjenige von dem ersten Widerstand, dem zweiten Widerstand oder der Batteriezelle, das mit der Impedanzmesseinheit verbunden wird, das Ziel ist;
Berechnen eines Innenwiderstands der Batteriezelle auf der Grundlage der Impedanz eines oder mehrerer Ziele, die von der Impedanzmesseinheit gemessen wird,
**dadurch gekennzeichnet, dass** das Verfahren weiter Folgendes umfasst:
Erzeugen eines Einstellungsparameters auf der Grundlage eines Impedanzwerts, der durch Anlegen jedes von dem ersten und dem zweiten Trägersignal an jedem von dem ersten Widerstand und dem zweiten Widerstand gemessen wird, und
Berechnen eines Innenwiderstands der Batteriezelle auf der Grundlage eines Impedanzwerts, der durch Anlegen des ersten und des zweiten Trägersignals an der Batteriezelle und des Einstellungsparameters gemessen wird.

9. Verfahren zur Messung des Batteriezellenwiderstands nach Anspruch 8, wobei das erste Trägersignal ein Trägersignal mit hoher Impedanz bei einer Frequenz von gleich oder kleiner als einer voreingestellten ersten Referenzfrequenz ist,
wobei das zweite Trägersignal ein Trägersignal mit hoher Impedanz bei einer Frequenz von gleich oder größer als einer voreingestellten zweiten Referenzfrequenz ist,
wobei die erste Referenzfrequenz kleiner als die zweite Referenzfrequenz ist.

10. Verfahren zur Messung des Batteriezellenwiderstands nach Anspruch 9, wobei das Berechnen des Innenwiderstands der Batteriezelle Folgendes umfasst:
Berechnen eines Gesamtinnenwiderstands, einschließlich eines Gleichstromkomponentenwiderstands und einer Wechselstromkomponentenimpedanz der Batteriezelle, auf der Grundlage des ersten Einstellungsparameters und eines vierten Impedanzwerts, der aus der Batteriezelle durch Anlegen des ersten Trägersignals an der Batteriezelle gemessen wird;
Berechnen des Gleichstromkomponentenwiderstands der Batteriezelle auf der Grundlage des zweiten Einstellungsparameters und eines fünften Impedanzwerts, der aus der Batteriezelle durch Anlegen des zweiten Trägersignals der zweiten Frequenz an der Batteriezelle gemessen wird; und
Berechnen der Wechselstromkomponentenimpedanz des Innenwiderstands der Batteriezelle durch Subtrahieren des berechneten Gleichstromkomponentenwiderstands vom berechneten Gesamtinnenwiderstand.

11. Verfahren zur Messung des Batteriezellenwiderstands nach Anspruch 8, wobei ein Widerstand des ersten Widerstands ein erwarteter minimaler Widerstandswert ist, wenn die Batteriezelle in einem offenen Spannungszustand ist,
wobei ein Widerstand des zweiten Widerstands ein erwarteter maximaler Widerstandswert ist, wenn die Batteriezelle in einem offenen Spannungszustand ist.

12. Verfahren zur Messung des Batteriezellenwiderstands nach Anspruch 8, wobei das Messen des Impedanzwerts des Ziels Folgendes umfasst:
Erzeugen eines I-Signals der gleichen Phase wie ein Impedanzsignal und eines Q-Signals, das um 90 Grad in Bezug auf das Impedanzsignal verzögert ist; und
Durchführen einer Signalverarbeitung zum Entfernen einer Geräuschkomponente aus dem gemessenen Impedanzsignal auf der Grundlage des erzeugten I-Signals und des erzeugten Q-Signals.

## Revendications

1. Dispositif de mesure de la résistance d'une cellule de batterie comprenant :
un module de génération de signal porteur (10) configuré pour générer un premier signal porteur à une première fréquence et un second signal porteur à une seconde fréquence différente de la première fréquence ;
une première résistance (21) ;
une seconde résistance (23) présentant une valeur de résistance différente de celle de la première résistance ;
une unité de mesure d'impédance (30) configurée pour mesurer une impédance d'une cible tandis que le premier ou le second signal porteur est appliqué à la cible ;
une unité de commutation (40) configurée pour relier sélectivement l'une quelconque parmi la première résistance, la seconde résistance et la cellule de batterie (1) à l'unité de mesure d'impédance, dans lequel celle parmi la première résistance, la seconde résistance ou la cellule de batterie qui est reliée à l'unité de mesure d'impédance est la cible ; et
une unité de commande (50) configurée pour calculer une résistance interne de la cellule de batterie sur la base de l'impédance d'une ou de plusieurs cibles mesurée par l'unité de mesure d'impédance,
dans lequel l'unité de commande (50) est configurée pour :
générer un paramètre d'ajustement sur la base d'une valeur d'impédance mesurée par application de chacun du premier signal porteur et du second signal porteur à chacune de la première résistance et de la seconde résistance, et
calculer une résistance interne de la cellule de batterie sur la base d'une valeur d'impédance mesurée par application du premier signal porteur et du second signal porteur à la cellule de batterie et du paramètre d'ajustement.

2. Dispositif de mesure de la résistance d'une cellule de batterie selon la revendication 1, dans lequel le premier signal porteur est un signal porteur à haute impédance à une fréquence égale ou inférieure à une première fréquence de référence prédéfinie,
dans lequel le second signal porteur est un signal porteur à haute impédance à une fréquence égale ou supérieure à une seconde fréquence de référence prédéfinie, et
dans lequel la première fréquence de référence est inférieure à la seconde fréquence de référence.

3. Dispositif de mesure de la résistance d'une cellule de batterie selon la revendication 1, dans lequel une résistance de la première résistance est une valeur de résistance minimale attendue lorsque la cellule de batterie est dans un état de tension ouverte,
dans lequel une résistance de la seconde résistance est une valeur de résistance maximale attendue lorsque la cellule de batterie est dans un état de tension ouverte.

4. Dispositif de mesure de la résistance d'une cellule de batterie selon la revendication 1, dans lequel l'unité de mesure d'impédance (30) comprend en outre une unité de traitement du signal configurée pour :
générer un signal I en phase avec un signal d'impédance reçu par l'intermédiaire de l'unité de mesure d'impédance et un signal Q déphasé de 90° par rapport au signal d'impédance ; et
éliminer une composante de bruit du signal d'impédance mesuré sur la base du signal I généré et du signal Q généré.

5. Dispositif de mesure de la résistance d'une cellule de batterie selon la revendication 1, dans lequel l'unité de commande (50) est configurée pour calculer une résistance de composante continue et une impédance de composante alternative d'une résistance interne en utilisant les premier et second signaux porteurs.

6. Dispositif de mesure de la résistance d'une cellule de batterie selon la revendication 5, dans lequel l'unité de commande (50) est configurée pour calculer une capacité de la cellule de batterie sur la base de la résistance de composante continue calculée et de l'impédance de composante alternative calculée.

7. Dispositif de mesure de la résistance d'une cellule de batterie selon la revendication 5, dans lequel l'unité de commande (50) est configurée pour estimer une durée de vie de la cellule de batterie sur la base de la résistance de composante continue calculée et de l'impédance de composante alternative calculée.

8. Procédé de mesure de la résistance d'une cellule de batterie comprenant :
la génération d'un premier signal porteur à une première fréquence et d'un second signal porteur à une seconde fréquence différente de la première fréquence ;
la mesure, au moyen d'une unité de mesure d'impédance, d'une impédance d'une cible tandis que le premier ou le second signal porteur est appliqué à la cible ;
la liaison sélective de l'une quelconque parmi une première résistance, une seconde résistance et une cellule de batterie (1) à l'unité de mesure d'impédance, dans lequel celle parmi la première résistance, la seconde résistance ou la cellule de batterie qui est reliée à l'unité de mesure d'impédance est la cible ;
le calcul d'une résistance interne de la cellule de batterie sur la base de l'impédance d'une ou de plusieurs cibles mesurée par l'unité de mesure d'impédance,
**caractérisé en ce que** le procédé comprend en outre :
la génération d'un paramètre d'ajustement sur la base d'une valeur d'impédance mesurée par application de chacun du premier signal porteur et du second signal porteur à chacune de la première résistance et de la seconde résistance, et
le calcul d'une résistance interne de la cellule de batterie sur la base d'une valeur d'impédance mesurée par application du premier signal porteur et du second signal porteur à la cellule de batterie et du paramètre d'ajustement.

9. Procédé de mesure de la résistance d'une cellule de batterie selon la revendication 8, dans lequel le premier signal porteur est un signal porteur à haute impédance à une fréquence égale ou inférieure à une première fréquence de référence prédéfinie,
dans lequel le second signal porteur est un signal porteur à haute impédance à une fréquence égale ou supérieure à une seconde fréquence de référence prédéfinie,
dans lequel la première fréquence de référence est inférieure à la seconde fréquence de référence.

10. Procédé de mesure de la résistance d'une cellule de batterie selon la revendication 9, dans lequel le calcul de la résistance interne de la cellule de batterie comprend :
le calcul d'une résistance interne totale incluant une résistance de composante continue et une impédance de composante alternative de la cellule de batterie sur la base du premier paramètre d'ajustement et d'une quatrième valeur d'impédance mesurée à partir de la cellule de batterie par application du premier signal porteur à la cellule de batterie ;
le calcul de la résistance de composante continue de la cellule de batterie sur la base du second paramètre d'ajustement et d'une cinquième valeur d'impédance mesurée à partir de la cellule de batterie par application du second signal porteur de la seconde fréquence à la cellule de batterie ; et
le calcul de l'impédance de composante alternative de la résistance interne de la cellule de batterie par soustraction de la résistance de composante continue calculée de la résistance interne totale calculée.

11. Procédé de mesure de la résistance d'une cellule de batterie selon la revendication 8, dans lequel une résistance de la première résistance est à une valeur de résistance minimale attendue lorsque la cellule de batterie est dans un état de tension ouverte,
dans lequel une résistance de la seconde résistance est à une valeur de résistance maximale attendue lorsque la cellule de batterie est dans un état de tension ouverte.

12. Procédé de mesure de la résistance d'une cellule de batterie selon la revendication 8, dans lequel la mesure de la valeur d'impédance de la cible comprend :
la génération d'un signal I en phase avec un signal d'impédance et d'un signal Q déphasé de 90° par rapport au signal d'impédance ; et
la mise en œuvre d'un traitement du signal pour éliminer une composante de bruit du signal d'impédance mesuré sur la base du signal I généré et du signal Q généré.
